# EUROPEAN PATENT SPECIFICATION

(11) **EP 2 573 819 B1**
(45) Date of publication and mention of the grant of the patent: **11.05.2016**
(21) Application number: 11009531.2
(22) Date of filing: 01.12.2011
(51) Int. Cl.: H01L 31/0224, H01L 31/068, H01L 31/048

(54) **Bifacial solar cell module**
Beidseitiges Solarzellenmodul
Module de pile solaire biface

(30) Priority: 20.09.2011 KR 20110094422
(43) Date of publication of application: 27.03.2013
(73) Proprietor: LG Electronics Inc., Yeongdeungpo-gu Seoul 150-721 (KR)
(72) Inventor: Woo, Taeki, Seoul, 137-724 (KR); Yu, Jemin, Seoul, 137-724 (KR); Kim, Taeyoon, Seoul, 137-724 (KR); Lee, Eunjoo, Seoul, 137-724 (KR); Mun, Seiyoung, Seoul, 137-724 (KR); Hong, Jongkyoung, Seoul, 137-724 (KR)
(74) Representative: Katérle, Axel

(56) References cited:
- EP-A2- 1 852 917
- WO-A1-2009/095273
- WO-A2-2007/002110
- RICKY SANTOSO ET AL: "Adhesion of encapsulating films used in PV module manufacturing", THERMAL AND THERMOMECHANICAL PHENOMENA IN ELECTRONIC SYSTEMS (ITHERM), 2010 12TH IEEE INTERSOCIETY CONFERENCE ON, IEEE, PISCATAWAY, NJ, USA, 2 June 2010 (2010-06-02), pages 1-4, XP031702238, ISBN: 978-1-4244-5342-9
- FRENCH R H ET AL: "Optical properties of materials for concentrator photovoltaic systems", PHOTOVOLTAIC SPECIALISTS CONFERENCE (PVSC), 2009 34TH IEEE, IEEE, PISCATAWAY, NJ, USA, 7 June 2009 (2009-06-07), pages 394-399, XP031626855, ISBN: 978-1-4244-2949-3
- FRENCH R H ET AL: "Optical properties of polymeric materials for concentrator photovoltaic systems", SOLAR ENERGY MATERIALS AND SOLAR CELLS, ELSEVIER SCIENCE PUBLISHERS, AMSTERDAM, NL, vol. 95, no. 8, 23 February 2011 (2011-02-23), pages 2077-2086, XP028229235, ISSN: 0927-0248, DOI: 10.1016/J.SOLMAT.2011.02.025 [retrieved on 2011-03-09]
- "Teflon(R) FEP frontsheets for photovoltaic modules: Improved optics leading to higher module efficiency", 2010 35TH IEEE PHOTOVOLTAIC SPECIALISTS CONFERENCE (PVSC) - 20-25 JUNE 2010, 25 May 2010 (2010-05-25), XP009159738,

## Description

### BACKGROUND

### Field

This document relates to a bifacial solar cell module.

### Related Art

Photovoltaic power generation that converts light energy to electrical energy using photoelectric conversion effect is widely used as a means that obtains non-polluting energy. With improvement of photoelectric conversion efficiency of a solar cell, a photovoltaic power generation system using a plurality of solar cell modules can be installed in an individual house.

A common solar cell comprises a substrate and an emitter forming a p-n junction with the substrate, and generates current using light applied through one side surface of the substrate.

Therefore, because light is applied through only one side surface of the substrate, a common solar cell has low current conversion efficiency. Accordingly, nowadays, a bifacial solar cell that can apply light through both side surfaces of the substrate has been developed.

In order to protect a solar cell from an external environment such as an external impact and moisture, a solar cell module having a plurality of solar cells for generating power by sunlight comprises a protective member disposed at an upper part and a lower part of the solar cell. EP-A-1 852 917 discloses a known solar cell module.

### SUMMARY

The bifacial solar cell module of the invention is defined in claim 1.

As an example, the first substrate may be made of low iron glass, and the second substrate may be made of the ETFE.

As another example, the first substrate may be made of the ETFE, and the second substrate may be made of low iron glass.

The substrate made of the ETFE may have a tensile strength of 40 MPa or more, have light transmittance of 90% or more, have light absorptance of 1% or less, and have an elongation ratio of 250% or more in a wavelength band 400 nm or more.

The substrate made of the ETFE may be formed with a thickness of 30 µm to 200 µm and may have a surface processed layer at a surface contacting with the seal member and at the surface opposite to a surface contacting with the seal member.

Here, a surface processed layer of the surface contacting with the seal member is a primer layer for reinforcing adhesive strength with the seal member, and in order to prevent moisture penetration, a surface processing layer positioned at the surface opposite to the surface contacting with the seal member is made of a hydrophobic material such as a hydroxyl group, an amino group, and a carboxyl group.

The bonding surface of the substrate made of the ETFE and the seal member may be formed with a non-flat surface.

The seal member may comprise silicone resin and further comprise a fiber material.

The fiber material may be one of a mesh form of glass fiber, quartz fiber, graphite fiber, nylon fiber, polyester fiber, aramid fiber, polyethylene fiber, polypropylene fiber, and silicon carbide fiber, and the silicone resin may be filled in space between individual fibers of the fiber material.

The seal member may comprise a first silicone resin positioned between the first substrate and the bifacial solar cell and a second silicone resin positioned between the bifacial solar cell and the second substrate, and the bonding surface of the first silicone resin and the second silicone resin may be formed as a non-flat surface.

The first silicone resin and the second silicone resin may have light transmittance of 80% or more in 300 nm to 500 nm.

According to such characteristics, the first substrate or the second substrate of the bifacial solar cell module is made of ETFE in which light transmittance is 85% or more and light absorptance is 5% or less in an entire wavelength band.

Particularly, ETFE used as the first substrate or the second substrate has light transmittance of an average 90% or more and light absorptance of 1 % or less in a wavelength band of 400 nm or more and can be thus matched to a high light transmittance of a seal member without light damage. Therefore, when the substrate made of ETFE is used as a back sheet, light is effectively applied through the substrate and thus an efficiency of the bifacial solar cell module increases.

The substrate made of ETFE hardly absorbs light of an ultraviolet ray band of the 300 nm to 500 nm, and thus has no damage due to ultraviolet rays.

Further, the substrate made of ETFE has a tensile strength of 40 MPa or more and an elongation ratio of 250% or more, and thus has excellent mechanical strength and is strong on module deformation.

Further, the substrate made of ETFE can be manufactured to a thickness, for example, 50 µm or less, smaller than a common substrate made of a tedlar or PET-based material within a range of 30 µm to 200 µm, and thus has excellent heat conductivity. Therefore, heat generated in a solar cell module can be effectively emitted.

Further, the substrate made of ETFE has low moisture penetration, compared with a common substrate made of a tedlar or PET-based material, and thus has excellent reliability with respect to moisture.

Further, because ETFE has a very stable material structure and has a melting point of 250°C of more, the substrate made of ETFE is resistant to heat and has a hydrophobic surface, and thus is very advantageous for moisture penetration prevention.

Further, because ETFE forming the substrate has a refractive index very similar to that of a silicone resin used as the seal member and has very low reflection in an interface with the seal member, ETFE has a very excellent light transmittance.

A silicone resin constituting the seal member has high light transmittance in a short wavelength band, for example, in an ultraviolet ray band, compared with a common seal member such as ethylene vinyl acetate (EVA) or polyvinyl butyral (PVB). For example, a silicone resin constituting the seal member has light transmittance of 80% or more in an ultraviolet ray band.

Therefore, a decolorization problem of the seal member due to exposure of ultraviolet rays can be suppressed, and by increasing the light quantity applied to a solar cell, the output of a solar cell module can be improved.

Because a silicone resin can be formed with a thickness smaller than that of ethylene vinyl acetate (EVA) used as an existing seal member, the thickness of the module can be reduced.

When the interface of the first seal material and the second seal material and/or the interface of the seal material and the back substrate are formed as a non-flat surface, light applied through the first substrate and the second substrate is diffusedly reflected at the interface and thus a light quantity applied to the solar cell increases and thus an output of the solar cell module is improved.

When a fiber material is positioned at the inside of the seal member, the strength of the solar cell module increases and cracks are prevented due to the fiber material. Further, while performing a lamination process, distortion of the silicone resin is prevented.

Further, because the silicone resin has a low curing temperature, a modularization process can be performed at a lower temperature and curing time can be shortened.

### BRIEF DESCRIPTION OF THE DRAWINGS

FIG. 1 is a conceptual diagram illustrating a schematic configuration of a bifacial solar cell module according to a first example not falling under the invention.
FIG. 2 is a graph illustrating an extinction coefficient of silicone resin and ethylene vinyl acetate according to a wavelength band of light;
FIG. 3 is an enlarged view illustrating a portion "C" of FIG. 1.
FIG. 4 is a graph illustrating the light transmittance of a back substrate according to the wavelength of light;
FIG. 5 is a graph illustrating the light absorptance of a back substrate according to the wavelength of light;
FIG. 6 is a cross-sectional view illustrating a bifacial solar cell used for a bifacial solar cell module according to another example not falling under the invention;
FIG. 7 is a diagram illustrating a method of manufacturing the bifacial solar cell module of FIG. 1;
FIG. 8 is a conceptual diagram illustrating a schematic configuration of a bifacial solar cell module according to a first modified example of FIG. 1;
FIG. 9 is a conceptual diagram illustrating a schematic configuration of a bifacial solar cell module according to a second modified example of FIG. 1;
FIG. 10 is a conceptual diagram illustrating a schematic configuration of a bifacial solar cell module according to a further example not falling under the invention;
FIG. 11 is an enlarged view illustrating a portion "D" of FIG. 10;
FIG. 12 is an enlarged view illustrating a portion "E" of FIG. 10;
FIG. 13 is a conceptual diagram illustrating a schematic configuration of a bifacial solar cell module according to the invention; and
FIG. 14 is a diagram illustrating a method of manufacturing the bifacial solar cell module of FIG. 13.

### DETAILED DESCRIPTION

In the following detailed description, only certain examples and embodiments are shown and described, simply by way of illustration. As those skilled in the art will realize, the described implementations may be modified in various different ways, all without departing from the invention. Accordingly, the drawings and description are to be regarded as illustrative in nature and not restrictive. Like reference numerals designate like elements throughout the specification.

In the drawings, the thickness of layers, films, panels, regions, etc., are exaggerated for clarity. When it is said that any part, such as a layer, film, region, or plate, is positioned on another part, it means the part is directly on the other part or above the other part with at least one intermediate part. In contrast, when an element is referred to as being "directly on" another element, there are no intervening elements present.

Further, when any portion is referred to as being "entirely" formed on another portion, it means the part is formed on an entire surface of the other part and is not formed in a portion of the edge.

Hereinafter, a solar cell module according to an example not falling under the invention will be described with reference to the attached drawings.

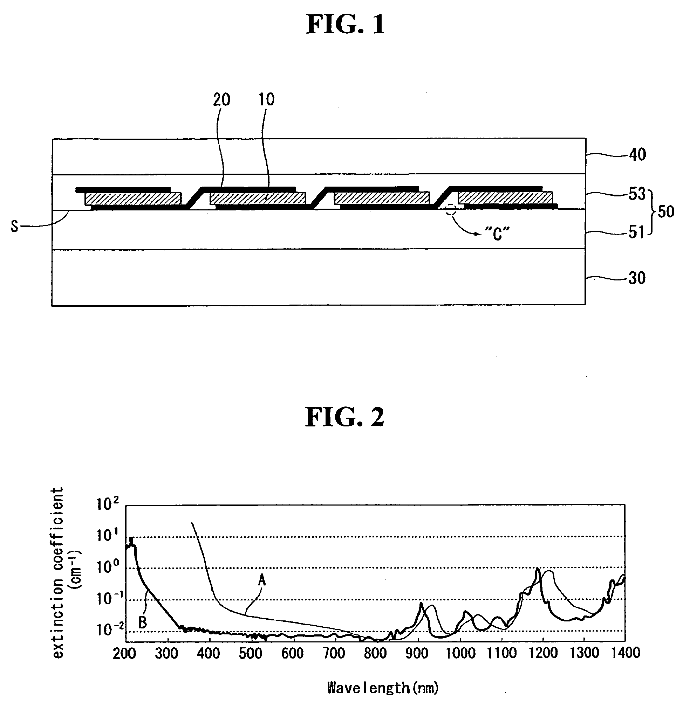

FIG. 1 is a conceptual diagram illustrating a schematic configuration of a solar cell module not falling under the invention but showing features of the module of the invention.

The solar cell module according to this example comprises a plurality of bifacial solar cells 10, an interconnector 20 for electrically connecting the plurality of bifacial solar cells 10, a light transmitting front substrate 30 positioned at a first surface, for example, the front surface side of the bifacial solar cell 10, a light transmitting back substrate 40 positioned at a second surface, for example the back surface side of the bifacial solar cell 10, and a seal member 50 positioned between the front substrate 30 and the back substrate 40.

The light transmitting front substrate 30 is made of tempered glass having a high transmittance of light to the solar cell 10. In this case, tempered glass may be low-iron tempered glass having a low iron ingredient content. In order to enhance the scattering effect of light, the light transmitting front substrate 30 may have an inner side surface in which an embossing process is performed.

The seal member 50 comprises a first seal material 51 positioned between the bifacial solar cell 10 and the front substrate 30 and a second seal material 53 positioned between the bifacial solar cell 10 and the back substrate 40, which prevents metal corrosion due to moisture penetration, and protects the bifacial solar cell 10 from impact.

The bifacial solar cell 10 generates current using light applied through the front surface and the back surface.

As the seal member has excellent transmittance, efficiency of the bifacial solar cell module is improved.

In the present example, the first seal material 51 and the second seal material 53 are made of silicone resin having a light transmittance of 80% or more in a short wavelength band, for example 300 nm to 500 nm. The first seal material 51 and the second seal material 53 are formed by applying and curing liquid silicone resin.

The silicone resin forming the first seal material 51 and the second seal material 53 is made of siloxane such as polydimethylsiloxane (PDMS) or polydialkylsiloxane (PDAS).

Referring to FIG. 2, the extinction coefficient (cm⁻¹) of silicone resin and ethylene vinyl acetate (EVA) according to a wavelength of light will be described.

In the graph shown in FIG. 2, graph "A" is a graph illustrating a change of the extinction coefficient of EVA according to wavelength, and graph "B" is a graph illustrating a change of the extinction coefficient of the first seal material 51 and the second seal material 53 according to wavelength.

EVA used in an experiment is a common product used as a seal member of a solar cell, and the silicone resin used in the graph "B" is PDMS.

As shown in FIG. 2, the extinction coefficient of EVA in a short wavelength band, for example, 300 nm to 500 nm is larger than that in PDMS. Therefore, silicone resin is lower in light absorptance in a short wavelength band than EVA.

It is well to transmit light of a short wavelength band where light absorptance is low in the short wavelength band. According to an experiment of the present inventor, silicone resin, more specifically, siloxane such as PDMS or PDAS has a light transmittance of 80% or more in the short wavelength band.

Therefore, when the first seal material 51 and the second seal material 53 are made of silicone resin, the amount of light absorbed in the first seal material 51 and the second seal material 53 decreases, and thus the amount of light applied to the bifacial solar cell 10 increases. Therefore, the output efficiency of the solar cell module is improved.

Because a decolorization problem of the first seal material 51 and the second seal material 53 due to exposure of ultraviolet rays and a corrosion problem due to absorption of air and oxygen may be suppressed, the durability of the module increases.

Because the first seal material 51 and the second seal material 53 may be formed with a thickness smaller than that of EVA used as an existing seal material, the thickness of the module may be reduced.

For example, EVA is formed with a thickness of about 1.0mm, but the first seal material 51 and the second seal material 53 may be each formed with a thickness of about 0.7mm or less, preferably a thickness of 0.3 mm to 0.5 mm. Therefore, the entire thickness of a bifacial solar cell module may be reduced, when compared with a conventional case.

Further, because the curing temperature of silicone resin is lower than that of EVA, a modularization process may be performed at a lower temperature, and curing time may be shortened.

For example, silicone resin is cured at a temperature of about 80°C or more, for example 90°C to 150°C, but EVA is cured at a temperature of about 165°C. Therefore, the modularization process may be performed at a lower temperature.

In order to cure silicone resin, a time of about 1.5 minutes is spent, but in order to cure EVA, a time of about 16 minutes is spent. Therefore, the time spent for the curing and modularization process of the seal material may be shortened.

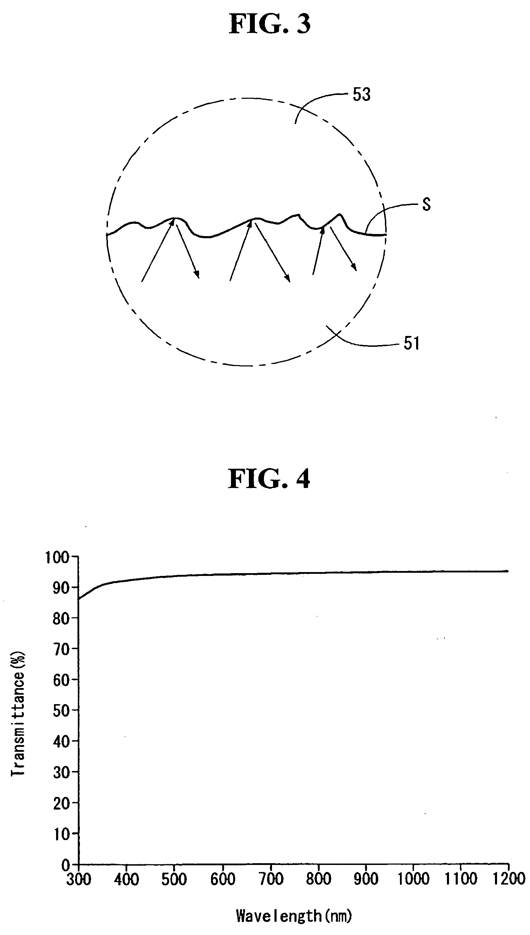

An interface S of the first seal material 51 and the second seal material 53 is formed as an uneven surface, as shown in an enlarged portion of FIG. 3. Here, an uneven surface, i.e., a non-flat surface indicates a bumpy surface in which unevenness is formed.

The reason why the interface S of the first seal material 51 and the second seal material 53 is formed as a non-flat surface is that the first seal material 51 is formed by curing a coated liquid silicone resin at a setting temperature and then the second seal material 53 is formed on the first seal material 51 by curing a coated liquid silicone resin at a setting temperature.

In this way, when the interface S of the first seal material 51 and the second seal material 53 is formed as a non-flat surface, light transmitted to the first seal material 51 is diffusedly reflected at the interface S, as indicated by an arrow. Therefore, light quantity applied to the solar cell increases.

As shown in FIG. 1, the bifacial solar cell 10 is positioned at an upper part of the first seal material 51. That is, a plurality of bifacial solar cells 10 are disposed at an upper part of the interface S of the first seal material 51 and the second seal material 53. Therefore, a side portion and an upper part of the solar cell 10 are covered by the second seal material 53.

In the bifacial solar cell module, the back substrate 40 should have enough electric insulating property, moistureproof property, and durability, and should have enough transmittance for light incidence through the back substrate 40.

In order to satisfy such a requirement, in the present implementation, an ethylene tetrafluoroethylene (hereinafter, referred to as 'ETFE') copolymer in which light transmittance is 85% or more and light absorptance is 5% or lower in an entire wavelength band, particularly, in which light transmittance is average 90% or more and light absorptance is 1% or less in a wavelength band of 400 nm to 1200 nm is used as the material of the back substrate 40.

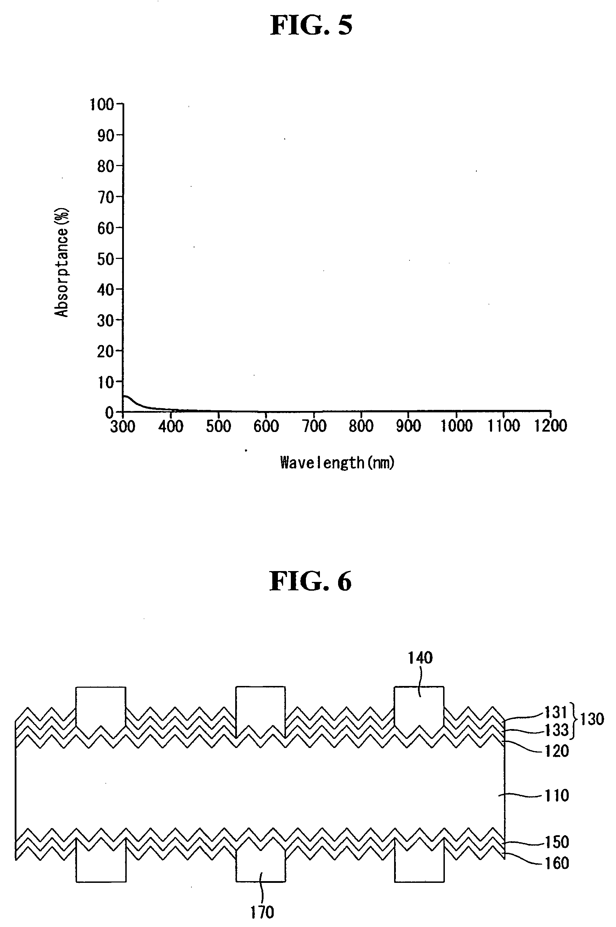

FIG. 4 is a graph illustrating light transmittance of the back substrate 40 according to the wavelength of light, and FIG. 5 is a graph illustrating light absorptance of the back substrate 40 according to the wavelength of light.

Here, to use ETFE as the material of the back substrate 40 generally means that a major ingredient of the material forming the back substrate 40 is ETFE, and additives may be added to the major ingredient, as needed.

However, it is preferable that the weight ratio of ETFE to the entire resin constituting the back substrate 40 is 100 wt%.

ETFE is a fluorine resin film, which has a repetition unit based on tetrafluoroethylene (TPE) and a repetition unit based on ethylene, and has a repetition unit based on other monomers in addition to the repetition unit.

In this case, only one type of monomers is used, however, at least two types of monomers may be used.

The number average molecular weight of ETFE is not particularly limited, but 100,000 to 500,000 is preferable and 200,000 to 400,000 is more preferable as a number average molecular weight of ETFE.

When the number average molecular weight of ETFE is 100,000 or more, in a heat resistance test, the strength does not deteriorate, and when a number average molecular weight of WTFE is 500,000 or less, the back substrate 40 may be formed with a small thickness.

Therefore, the back substrate 40 made of ETFE having a light transmittance characteristic and a light absorption characteristic may be matched to high light transmittance of the first seal material 51 and the second seal material 53 without light damage.

Further, the back substrate 40 made of ETFE has a tensile strength of 40 MPa or more and an elongation ratio of 250% or more, and thus has excellent mechanical strength and is strong on module deformation.

Further, the back substrate 40 made of ETFE can be manufactured within a range of 30 µm to 200 µm. Particularly, because the back substrate 40 made of ETFE can be manufactured with a thickness of for example, 50 µm or less, which thickness is smaller than a common back substrate made of a tedlar or PET-based material, the back substrate 40 made of ETFE has excellent heat conductivity. Therefore, heat generated in the solar cell module may be effectively dissipated.

Further, the back substrate 40 made of ETFE has low moisture penetration, compared with a common back substrate made of tedlar or PET-based material, and thus the back substrate 40 made of ETFE has excellent reliability against moisture.

Further, ETFE has a very stable material structure and has a melting point of 250°C or more, and thus the back substrate 40 made of ETFE has strong resistance to heat and has a hydrophobic surface, thereby being very advantageous for preventing moisture penetration.

Further, ETFE has a refractive index of about 1.4. Therefore, ETFE forming the back substrate 40 has a refractive index that is very similar to silicone resin forming the first seal material 51 and the second seal material 53 and has much less reflection in an interface with the second seal material 53, and thus is very excellent in light transmittance.

The bonding surface of the second seal material 53 and the back substrate 40 may be formed as a non-flat surface, as in the interface of the first seal material 51 and the second seal material 53.

Therefore, because light is diffusedly reflected at the interface of the second seal material 53 and the back substrate 40, light quantity applied to the solar cell further increases.

FIG. 6 is a cross-sectional view illustrating a bifacial solar cell that may be used in a bifacial solar cell module according to the invention. However, a bifacial solar cell having various kinds and structures in addition to the solar cell shown in FIG. 6 may be used in the bifacial solar cell module according to the invention.

The bifacial solar cell 10 comprises a substrate 110, an emitter 120 positioned at one surface, for example, the front surface of the substrate 110, a first reflection prevention film 130 positioned on the emitter 120, a first electrode 140 positioned on the emitter 120 at an area in which the first reflection prevention film 130 is not positioned, a back surface field (BSF) portion 150 positioned at the back surface of the substrate 110, a second reflection prevention film 160 positioned at the back surface of the BSF portion 150, and a second electrode 170 positioned at the back surface of the BSF portion 150 at an area in which the second reflection prevention film 160 is not positioned.

The substrate 110 is formed with the first conductivity type, for example, an n-type silicon wafer. In this case, silicon may be monocrystalline silicon, polycris-talline silicon, or amorphous silicon. talline silicon, or amorphous silicon.

Because the substrate 110 is n-type, the substrate 110 contains impurities of a pentavalent element such as phosphorus P, arsenic As, and/or antimony Sb. In this case, it is preferable that the substrate 110 has a specific resistance of 1 Ωcm² to 10 Ωcm².

Alternatively, the substrate 110 may be-a p-type and may be made of semiconductor materials other than silicon.

When the substrate 110 is p-type, the substrate 110 may contain impurities of a trivalent element such as boron B, gallium Ga, and/or indium In.

The substrate 110 is formed with a textured surface in which at least one of the front surface and the back surface is textured.

The emitter 120 positioned at the textured surface of the front surface of the substrate 110 is an impurity portion having the second conductive type, for example, p-type conductivity opposite to the conductivity type of the substrate 110 and forms a p-n junction with the substrate 110.

By a built-in potential difference due to the p-n junction, electron-hole pairs, which are electric charges generated by light applied to the substrate 110 are separated into electrons and holes, and electrons move toward an n-type and holes move toward a p-type area.

Therefore, when the substrate 110 is n-type and the emitter 120 is p-type, separated electrons move toward the substrate 110 and separated holes move toward the emitter 120. Therefore, electrons become the plurality of carriers in the substrate 110, and holes become the plurality of carriers in the emitter 120.

When the emitter 120 is p-type, the emitter 120 may be formed by doping impurities of a trivalent element such as boron B, gallium Ga, and/or indium In to the substrate 110. In this case, it is preferable that the emitter 120 has surface resistance of 30 Ωs/sq to 120 Ωs/sq.

Alternatively, when the substrate 110 is p-type, the emitter 120 is n-type. In this case, separated holes move toward the substrate 110, and separated electrons move toward the emitter 120.

When the emitter 120 is n-type, the emitter 120 may be formed by doping impurities of a pentavalent element such as phosphorus P, arsenic As, and/or antimony Sb to the substrate 110.

The first reflection prevention film 130 formed on the emitter 120 of the front surface of the substrate 110 comprises a metal oxide-based material.

For example, the first reflection prevention film 130 comprises an upper film 131 formed as a silicon nitride film (SiNx:H) and a lower film 133 positioned between the emitter 120 and the upper film 131.

The lower film 133 is made of a material, for example, an aluminum oxide film AlOx having a large difference in extinction coefficient or a band gap Eg from a silicon nitride film.

The first reflection prevention film 130 comprising the lower film 133 of such a configuration functions as a reflection prevention film that reduces the reflectivity of light applied through the front surface of the substrate 110 and that increases the selectivity of a particular wavelength band and also functions as a passivation film.

A silicon oxide film (SiOx:H) instead of an aluminum oxide film 133 may be used as the lower film 133.

The first reflection prevention film 130 comprises a plurality of contact lines (not shown) that expose some of the emitter 120. The first electrode 140 is formed in the emitter 120 exposed through the contact line.

In order to form the first electrode 140 with a fine line width and a high aspect ratio, a contact line may be formed with a width of 20 µm to 60 µm and a plane area of 2% to 6% of that of the emitter 120.

When the contact line is formed with the width, if the first electrode 140 is formed using a plating process, the first electrode 140 may be formed with a thickness of 20 µm to 50 µm.

According to such a structure, the first electrode 140 has a high aspect ratio, for example, 0.83 to 1.

The first electrode 140 formed in the emitter 120 exposed through the contact line is electrically and physically connected to the emitter 120. In this case, the first electrode 140 is extended in an almost parallel direction.

The first electrode 140 collects electric charges, for example, holes moved toward the emitter 120. In this document, the first electrode 140 may be a finger electrode. Alternatively, the first electrode 140 may be both a finger electrode and a current collector for the finger electrode.

In the present example, the first electrode 140 is formed with a plating layer, and the plating layer comprises a metal seed layer, a diffusion preventing layer, and a conductive layer sequentially formed on the emitter 120.

The metal seed layer may be made of a material comprising nickel, for example, nickel silicide (comprising Ni₂Si, NiSi, NiSi₂, etc.) and is formed with a thickness of 50 nm to 200 nm.

Here, the reason of limiting the thickness of the metal seed layer to the above range is that when the thickness of the metal seed layer is less than 50 nm, the metal seed layer has a high resistance and it is difficult for the metal seed layer to be formed as a uniform film, and thus it is not easy to secure uniformity in a plating process of a diffusion preventing layer being performed later. When the thickness of the metal seed layer is 200 nm or more, the metal seed layer is diffused toward silicon with a constant ratio in a heat treatment process, and thus forms a nickel silicide layer, whereby shunt leakage may occur due to nickel diffusion.

The diffusion preventing layer formed on the metal seed layer is to prevent junction degradation from occurring as the material constituting the conductive layer is diffused to a silicon interface through the metal seed layer and comprises nickel formed in a thickness of 5 µm to 15 µm.

The conductive layer formed on the diffusion preventing layer comprises at least one conductive metal material. An example of the conductive metal material may be at least one selected from the group including nickel Ni, copper Cu, silver Ag, aluminum Al, tin Sn, zinc Zn, indium In, titanium Ti, and gold Au, and a combination thereof and may be other conductive metal materials as well.

In the present example, the conductive layer comprises a copper layer. The copper layer functions as a substantial electrical conductive wire and is formed with a thickness of 10 µm to 30 µm. However, copper is easily oxidized in air and it is not easy to directly solder an interconnector, for example, a ribbon (not shown) that electrically connects adjacent solar cells with the copper layer in a modularization process.

Therefore, when the conductive layer comprises a copper layer, in order to prevent oxidation of copper and to smoothly perform a soldering operation of a ribbon, a tin layer is further formed on the copper layer and is formed with a thickness of 5 µm to 15 µm.

In the case where the conductive layer is made of another metal material other than copper when the other metal material is not easily oxidized in air and is soldered with a ribbon, the tin layer may be omitted.

When the first electrode 140 is a finger electrode, a current collector for collecting electric charges moved to the finger electrode may be further formed at the front surface of the substrate 110. The current collector may be formed as a plating electrode, as for the first electrode 140, but the current collector may be formed by printing, drying, and firing conductive paste containing a conductive material.

The second electrode 170 positioned at the back surface of the substrate 110 collects electric charges, for example, electrons moving toward the substrate 110 and outputs the electric charges to an external device. In this document, the second electrode 170 may be a finger electrode. Alternatively, the second electrode 170 may be both a finger electrode and a current collector for the finger electrode.

The second electrode 170 may be made of at least one conductive material selected from the group including aluminum A, nickel Ni, copper Cu, silver Ag, tin Sn, zinc Zn, indium In, titanium Ti, and gold Au, and a combination thereof.

The second electrode 170 may be formed with conductive paste containing silver Ag particles or may be formed with a plating layer, as for the first electrode 140.

The second electrode 170 may be formed with the same width as or a width larger than that of the first electrode 140, and when the width of the second electrode 170 is larger than that of the first electrode 140, the line resistance of the second electrode 170 may be reduced.

The BSF portion 150 in which the second electrode 170 is electrically and physically connected is positioned at the entire back surface of the substrate 110, and impurities of the same conductivity type as that of the substrate 110 are formed as an area, for example, an n⁺ area doped with a concentration higher than that of the substrate 110. In this case, it is preferable that the BSF portion 150 has a surface resistance of 50 Ωs/sq to 150 Ωs/sq.

The BSF portion 150 forms a potential barrier due to an impurity concentration dif ference with the substrate 110, thereby preventing hole movement toward the back surface of the substrate 110. Therefore, by recoupling of electrons and holes at the periphery of the surface of the substrate 110, disappearance of electrons and holes is decreased.

The second reflection prevention film 160 is positioned at the back surface of the BSF portion 150 at which the second electrode 170 is not positioned, and the second reflection prevention film 160 is formed as a silicon nitride film (SiNx:H).

In a solar cell of such a structure, when light striking the solar cell is applied to the substrate 110 through the emitter 120 and the BSF portion 150, electron-hole pairs are generated by light energy applied to the substrate 110.

In this case, because the front surface and the back surface of the substrate 110 are each formed as a textured surface, light reflectance at the front surface and the back surface of the substrate 110 decreases and an incidence and reflection operation is performed at the textured surface, and thus light is sustained within the solar cell, whereby an absorptance of light increases, and thus the efficiency of the solar cell is improved.

In addition thereto, as reflection loss of light applied to the substrate 110 by the first reflection prevention film 130 and the second reflection prevention film 160 decreases, the quantity of light applied to the substrate 110 further increases.

The electron-hole pairs are separated by a p-n junction of the substrate 110 and the emitter 120, and electrons move toward the substrate 110 having n-type conductivity, and holes move toward the emitter 120 having p-type conductivity.

In this method, electrons moved toward the substrate 110 move to the second electrode 170 through the BSF portion 150 and holes moved toward the emitter 120 move to the first electrode 140.

Therefore, as shown in FIG. 1, when the second electrode 170 of a solar cell adjacent to the first electrode 140 of any one solar cell is connected to a conductive wire such as the interconnector 20, current flows and is used outside as electric power.

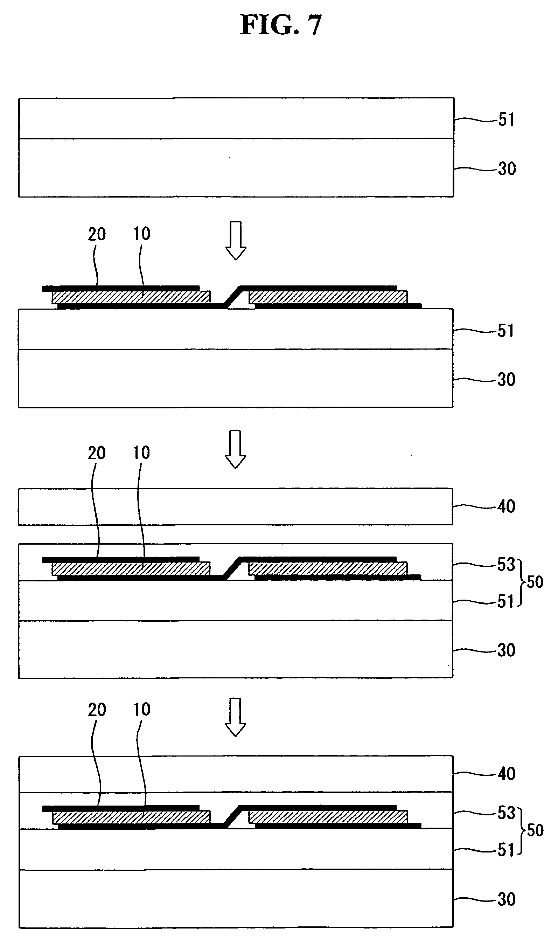

Hereinafter, a method of manufacturing the solar cell module shown in FIG. 1 will be described with reference to FIG. 7.

First, silicone resin is applied to a thickness of 3 mm to 5 mm at one surface of the front substrate 30 and is leveled by leaving for 30 seconds to 60 seconds.

In this case, the applied silicone resin is prevented from overflowing outside the area of the front substrate 30 by installing a frame of a predetermined height enclosing the front substrate 30.

Thereafter, the front substrate to which liquid silicone resin is applied is disposed at an oven, and at a temperature of 80°C or more, for example 90°C to 150°C, the silicone resin is cured by performing a curing process for 60 seconds to 120 seconds, and the first seal material 51 is formed.

When the curing process is performed, the first seal material 51 is adhered to the front substrate and the other surface of the first seal material 51, i.e., the surface opposite to the surface adhered to the front substrate is formed as a non-flat surface.

Thereafter, a plurality of solar cells 10 are disposed on the first seal material 51, and the silicone resin is applied to a thickness of 3 mm to 5 mm and then is left for 30 seconds to 60 seconds, and thus the silicone resin is leveled.

In this case, the operation of applying liquid silicone resin in order to form the second seal material 53 may be performed in a state where a frame is installed, as in the operation of applying silicone resin in order to form the first seal material 51.

Due to the application and leveling operation of the silicone resin, the liquid silicone resin is filled in spaces between the adjacent solar cells 10 and in spaces between the solar cell 10 and the first seal material 51.

Thereafter, the front substrate is disposed in an oven, and the silicone resin is cured by performing a curing process for 60 seconds to 120 seconds at a temperature of 80°C or more, for example, 90°C to 150°C, and a second seal material 53 is formed.

When the curing process is performed, the second seal material 53 is adhered to the first seal material 51, and the other surface of the second seal material 53, i.e., the surface opposite to the surface adhered to the first seal material 51 is formed as a non-flat surface.

Thereafter, the back substrate 40 is disposed on the second seal material 53, and by performing, for example, a lamination process, the back substrate 40 is adhered to the second seal material 53.

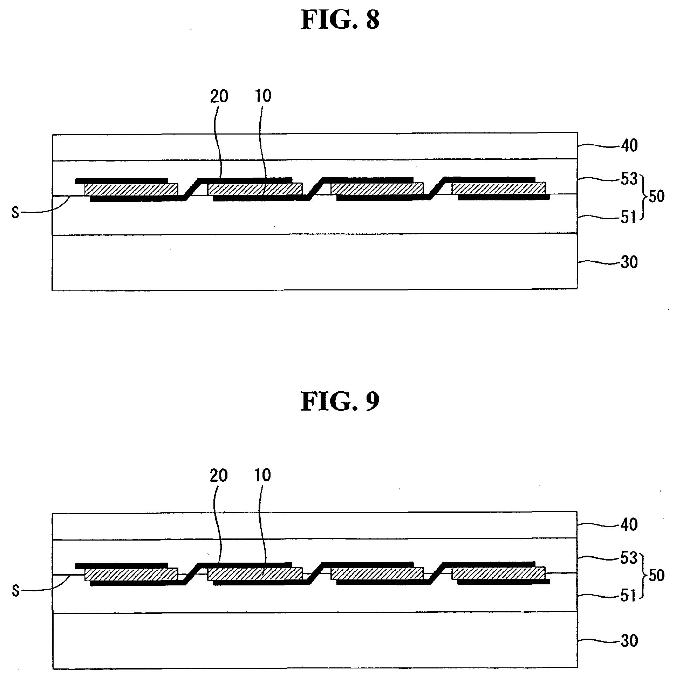

Hereinafter, a bifacial solar cell module according to a modified example of FIG. 1 will be described with reference to FIGS. 8 and 9.

In the following description of a further example, constituent elements identical to or corresponding to those of the first example are denoted by the same reference numerals and therefore a detailed description thereof will be omitted.

FIG. 8 is a conceptual diagram illustrating a schematic configuration of a bifacial solar cell module according to a first modified example of FIG. 1, and FIG. 9 is a conceptual diagram illustrating a schematic configuration of a bifacial solar cell module according to a second modified example of FIG. 1.

In the modified examples of FIGS. 8 and 9, the remaining configuration is the same as that of the first example except that a portion of the bifacial solar cell 10 is embedded in the first seal material 51.

FIG. 8 illustrates that the interconnector 20 positioned at the first surface of the bifacial solar cell 10 is embedded in the first seal material 51, and FIG. 9 illustrates that the interconnector 20 positioned at the first surface of the bifacial solar cell 10 and a portion of the bifacial solar cell 10 are embedded in the first seal material 51.

As shown in FIGS. 8 and 9, when the interconnector 20 or a portion of the interconnector 20 and the bifacial solar cell 10 is embedded in the first seal material 51, the position of the bifacial solar cell 10 is fixed by the first seal material 51, and thus the problem that an erroneous alignment occurs in the following modularization process may be suppressed.

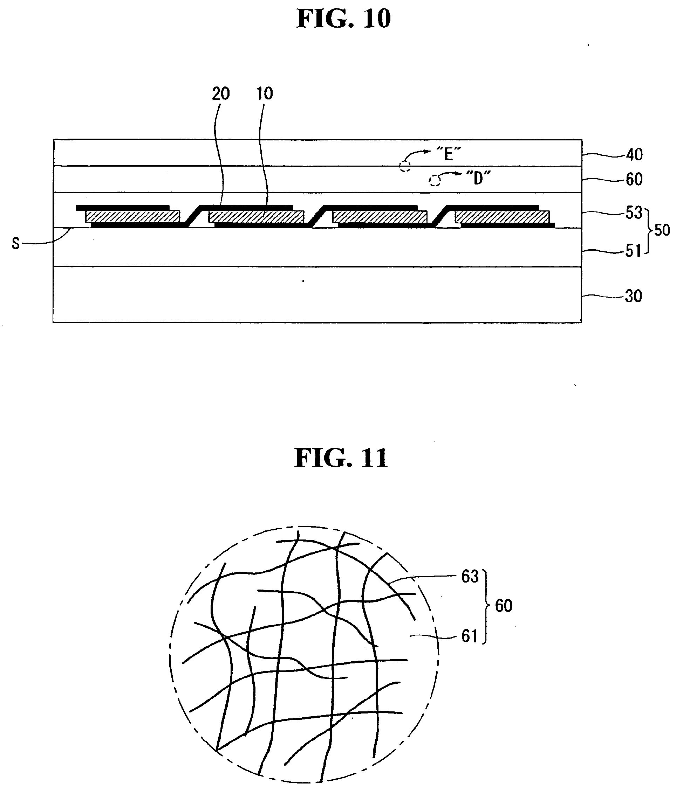

Hereinafter, a bifacial solar cell module according to various examples not falling under the invention, and embodiments of the invention will be described with reference to FIGS. 10 to 14.

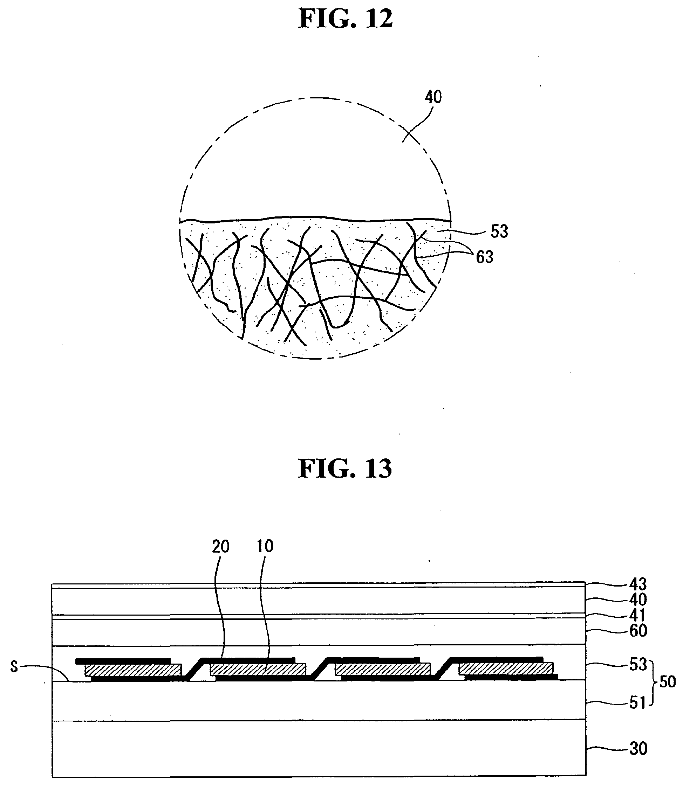

FIG. 10 is a conceptual diagram illustrating a schematic configuration of a solar cell module according to a second example not falling under the invention, FIG. 11 is an enlarged view illustrating a portion "D" of FIG. 10, and FIG. 12 is an enlarged view illustrating a portion "E" of FIG. 10.

In the present example, the remaining configuration is the same as that of the first example except that a fiber material 60 is disposed on the back substrate 40 and the seal member is made of only the first seal material 51.

That is, in the bifacial solar cell module of the present example, a seal member positioned between the front substrate 30 and the back substrate 40 is formed with only the first seal material 51 used in the example of FIG. 1.

The fiber material 60 is positioned between the bifacial solar cell 10 and the back substrate 40.

As shown in an enlarged portion of FIG. 11, the fiber material 60 comprises individual fibers 63 separated by spaces 61. Therefore, the fiber material 60 is formed in a mesh form.

The fiber material 60 of such a configuration is positioned at the side closest to the back substrate 40 of the solar cell. For example, the fiber material 60 contacts with the back substrate 40, as shown in FIG. 10.

Because the fiber material 60 is formed in a mesh form, the silicone resin forming the first seal material 51 is filled in the spaces 61 of the fiber material 60. In FIG. 11, in order to display the spaces 61, the silicone resin filled in the spaces 61 is not shown.

However, as described above, silicone resin is filled in the spaces 61 of the fiber material 60. That is, the first seal material 51 is filled in the spaces 61 of the fiber material 60.

FIG. 12 is an enlarged view illustrating a portion "E" of FIG. 10 and illustrates a state where at least a portion of the fiber material 60 is separated from the back substrate 40.

At least a portion of the fiber material 60 may be separated from the back substrate 40, as shown in FIG. 12, and in this case, the first seal material 53 is filled in the spaces 61 of the fiber material 60 and in the spaces between the fiber material 60 and the back substrate 40.

Therefore, when at least a portion of the fiber material 60 is separated from the back substrate 40 and when an entire portion of the fiber material 60 contacts with the back substrate 40, the back substrate 40 is adhered to the first seal material 51.

The fiber material 60 is made of glass fiber. For example, the fiber material 60 may be a glass fiber piece of style 106 of 8 inches X 8 inches (about 20.32 cm×20.32 cm) supplied by BGF Industries. However, the fiber material 60 is not limited to glass fiber.

For example, the fiber material 60 may be made of a glass fiber containing reinforcement material, a quartz fiber, a graphite fiber, a nylon fiber, a polyester fiber, an aramid fiber such as Kevlar and Nomex, a polyethylene fiber, a polypropylene fiber, and a silicon carbide fiber and is not limited thereto.

The fiber material 60 is formed to a thickness smaller than that of the first seal material 51 within a range of 0.3 mm to 0.5 mm.

When the fiber material 60 of such a configuration is disposed between the first seal material 51 and the back substrate 40, the strength of the solar cell module increases and cracks are prevented due to the fiber material 60. Further, while curing the silicone resin, distortion of the first seal material 51 is prevented, and thus leveling of the back substrate 40 is well performed.

A silicone resin is firstly applied on one surface of the front substrate 30, and after the solar cell 10 is disposed on the first applied silicone resin, in a state where the second silicone resin is applied on the solar cell 10, by performing a curing process, the first seal material 51 in which the solar cell 10 is embedded therein is formed, and then in a state where the fiber material 60 and the back substrate 40 are disposed on the first seal material 51, by performing a lamination process, a solar cell module of such a configuration is manufactured.

When performing a lamination process, the back substrate 40 may be pressed to fill silicone resin in the spaces 61 of the fiber material 60.

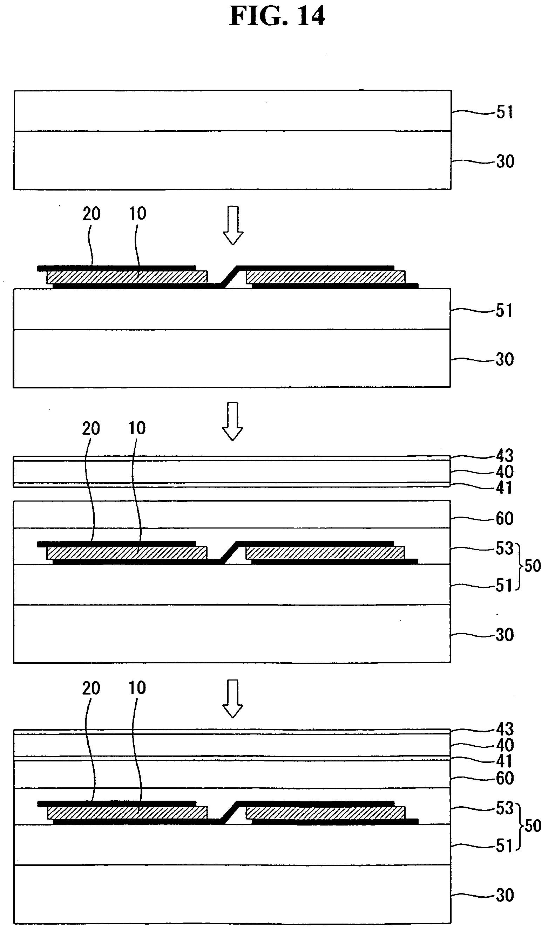

FIG. 13 is a conceptual diagram illustrating a schematic configuration of a bifacial solar cell module according to the invention, and FIG. 14 is a diagram illustrating a method of manufacturing the bifacial solar cell module of FIG. 13.

Referring to FIGS. 13 and 14, in a bifacial solar cell module of the present invention the remaining configuration is the same as that of the example of FIG. 1 except that the fiber material 60 is disposed between the second seal material 53 and the back substrate 40 and a first surface processing layer 41 and a second surface processing layer 43 are formed on surfaces of the back substrate 40.

The first surface processing layer 41 is formed at the surface adhered to the second seal material 53 and is a primer layer for reinforcing adhesive strength with the silicone resin constituting the second seal material 53.

The second surface processing layer 43 is formed at a surface opposite to the surface contacting with the second seal material 53, in order to prevent moisture penetration. The second surface processing layer 43 is made of a hydrophobic material such as a hydroxyl group, an amino group, and a carboxyl group.

Hereinafter, a method of manufacturing the bifacial solar cell module shown in FIG. 13 will be described with reference to FIG. 14.

First, according to the method of manufacturing the bifacial solar cell module of FIG. 6, the first seal material 51 is formed on one surface of the front substrate 30, the bifacial solar cell 10 is disposed on the first seal material 51, and then silicone resin is applied.

Thereafter, after a leveling operation of the silicone resin is complete, the fiber material 60 is disposed on the silicone resin.

When the fiber material 60 is disposed on a liquid silicone resin, while the silicone resin is pressed due to a weight of the fiber material 60, the silicone resin is filled in the spaces 61 formed between individual fibers 63 of the fiber material 60.

In this case, in order to well fill the silicone resin constituting the second seal material 53 in the spaces 61 between the individual fibers 63, the fiber material 60 may be pressed from above with a constant pressure.

Thereafter, the front substrate is disposed in an oven, and by curing the silicone resin by performing a curing process for 60 seconds to 120 seconds at a temperature of 80°C or more, for example 90°C to 150°C, the second seal material 53 is formed.

When the curing process is performed, the second seal material 53 is adhered to the first seal material 51, and one surface of the second seal material 53, i.e., the surface opposite to the surface adhered to the first seal material 51 is formed as a non-flat surface.

Thereafter, after the back substrate 40 is disposed on the fiber material 60, by performing a lamination process, the back substrate 40 is adhered to the second seal material 53.

In the foregoing description, it is exemplified that the back substrate 40 is made of ETFE, but the back substrate 40 may be made of low iron tempered glass, and the front substrate 30 may be made of ETFE.

## Claims

1. A bifacial solar cell module comprising:
a plurality of bifacial solar cells (10);
a light transmitting first substrate (30) positioned at a first surface side of the bifacial solar cells;
a light transmitting second substrate (40) positioned at the second surface side of the bifacial solar cells; and
a seal member (50) positioned between the first substrate (30) and the second substrate (40) and sealing the solar cells, the seal member being made of a sealing material of at least one layer (51, 53),
wherein at least one of the first substrate (30) and the second substrate (40) is made of an ethylene tetrafluoroethylene copolymer (ETFE),
**characterized in that** in the ETFE light transmittance is 85% or more and light absorptance is 5% or less in a wavelength band of 400 nm to 1200 nm,
wherein the substrate (30, 40) made of the ETFE has a first surface processed layer (41) at the surface contacting with the seal member (50), the first surface processed layer (41) being a primer layer for reinforcing adhesive strength with the seal member (50),
wherein the substrate (30, 40) made of the ETFE has a second surface processed layer (43) at the surface opposite to the surface contacting with the seal member (50), the second surface processed layer (43) being made of a hydrophobic material for preventing moisture penetration.

2. The bifacial solar cell module of claim 1, wherein the substrate (30, 40) made of ETFE has light transmittance of 90% or more in a wavelength band of 400 nm to 1200 nm.

3. The bifacial solar cell module of any preceding claim wherein the substrate (30, 40) made of ETFE has light absorptance of 1% or less in a wavelength band of 400 nm to 1200 nm.

4. The bifacial solar cell module of any preceding claim, wherein the substrate (30, 40) made of ETFE is formed in a thickness of 30 µm to 200 µm.

5. The bifacial solar cell module of any preceding claim, wherein the seal member (50) comprises silicone resin.

6. The bifacial solar cell module of claim 5, wherein the seal member further comprises a fiber material (60).

7. The bifacial solar cell module of claim 6, wherein the fiber material has a mesh form and is at least one of glass fiber, quartz fiber, graphite fiber, nylon fiber, polyester fiber, aramid fiber, polyethylene fiber, polypropylene fiber, and silicon carbide fiber, and the silicone resin is filled in the spaces between individual fibers of the fiber material.

8. The bifacial solar cell module of any one of claims 5 to 7, wherein the seal member (50) comprises a first silicone resin (51) positioned between the first substrate (30) and the bifacial solar cell (10) and a second silicone resin (53) positioned between the bifacial solar cell (10) and the second substrate (40).

9. The bifacial solar cell module of claim 8, wherein the first silicone resin (51) and the second silicone resin (53) have light transmittance of 80% or more in a wavelength band of 300 nm to 500 nm.

## Patentansprüche

1. Bifazial-Solarzellenmodul umfassend:
eine Mehrzahl Bifazial-Solarzellen (100),
ein Lichtdurchlässiges erstes Substrat (30), welches auf einer ersten Oberflächenseite der Bifazial-Solarzellen angeordnet ist,
ein lichtdurchlässiges zweites Substrat (40), welches auf der zweiten Oberflächenseite der Bifazial-Solarzellen angeordnet ist, und
ein Dichtelement (50), welches zwischen dem ersten Substrat (30) und dem zweiten Substrat (40) angeordnet ist und die Solarzellen abdichtet, wobei das Dichtelement aus einem wenigstens einlagigen (51, 53) Dichtmaterial gefertigt ist,
wobei das erste Substrat (30) oder/und das zweite Substrat (40) aus einem Ethylen-Tetrafluorethylen-Copolymer (ETFE) gefertigt ist,
**dadurch gekennzeichnet, dass** die ETFE-Lichtdurchlässigkeit 85% oder mehr beträgt und das Lichtabsorptionsvermögen 5% oder weniger beträgt in einem Wellenlängenband von 400 nm bis 1200 nm,
wobei das aus ETFE gefertigte Substrat (30, 40) eine erste oberflächenbehandelte Schicht (41) an der mit dem Dichtelement (50) in Kontakt stehenden Oberfläche aufweist, wobei die erste oberflächenbehandelte Schicht (41) eine Grundierungslage zur Verstärkung der Klebkraft mit dem Dichtelement (50) ist,
wobei das aus ETFE gefertigte Substrat (30, 40) eine zweite oberflächenbehandelte Schicht (43) an der Oberfläche aufweist, welche der in Kontakt mit dem Dichtelement (50) stehenden Oberfläche gegenüberliegt, wobei die zweite oberflächenbehandelte Schicht (43) aus einem hydrophoben Material zur Verhinderung des Eindringens von Feuchtigkeit gefertigt ist.

2. Bifazial-Solarzellenmodul nach Anspruch 1, wobei das aus ETFE gefertigte Substrat (30, 40) eine Lichtdurchlässigkeit von 90% oder mehr in einem Wellenlängenband von 400 nm bis 1200 nm besitzt.

3. Bifazial-Solarzellenmodul nach einem vorhergehenden Anspruch, wobei das aus ETFE gefertigte Substrat (30, 40) ein Lichtabsorptionsvermögen von 1% oder weniger in einem Wellenlängenband von 400 nm bis 1200 nm besitzt.

4. Bifazial-Solarzellenmodul nach einem vorhergehenden Anspruch, wobei das aus ETFE gefertigte Substrat (30, 40) mit einer Dicke von 30 µm bis 200 µm gebildet ist.

5. Bifazial-Solarzellenmodul nach einem vorhergehenden Anspruch, wobei das Dichtelement (50) ein Silikonharz umfasst.

6. Bifazial-Solarzellenmodul nach Anspruch 5, wobei das Dichtelement ferner ein Fasermaterial (60) umfasst.

7. Bifazial-Solarzellenmodul nach Anspruch 6, wobei das Fasermaterial Netzform besitzt und mindestens eines von Glasfaser, Quarzfaser, Grafitfaser, Nylonfaser, Polyesterfaser, Aramidfaser, Polyethylenfaser, Polypropylenfaser und Siliziumcarbidfaser ist und wobei das Silikonharz in die Räume zwischen einzelnen Fasern des Fasermaterials eingefüllt ist.

8. Bifazial-Solarzellenmodul nach einem der Ansprüche 5 bis 7, wobei das Dichtelement (50) ein erstes Silikonharz (51), welches sich zwischen dem ersten Substrat (30) und der Bifazial-Solarzelle (10) befindet, und ein zweites Silikonharz (53) umfasst, welches sich zwischen der Bifazial-Solarzelle (10) und dem zweiten Substrat (40) befindet.

9. Bifazial-Solarzellenmodul nach Anspruch 8, wobei das erste Silikonharz (51) und das zweite Silikonharz (53) eine Lichtdurchlässigkeit von 80% oder mehr in einem Wellenlängenband von 300 nm bis 500 nm besitzen.

## Revendications

1. Module de cellules solaires bifaces comprenant :
une pluralité de cellules solaires bifaces (10) ;
un premier substrat (30) transmettant la lumière positionné au niveau d'un premier côté de surface des cellules solaires bifaces ;
un deuxième substrat (40) transmettant la lumière positionné au niveau du deuxième côté de surface des cellules solaires bifaces ; et
un élément de scellage (50) positionné entre le premier substrat (30) et le deuxième substrat (40) et scellant les cellules solaires, l'élément de scellage étant constitué d'un matériau de scellage d'au moins une couche (51, 53),
dans lequel au moins un du premier substrat (30) et du deuxième substrat (40) est constitué d'un copolymère d'éthylène-tétrafluoroéthylène (ETFE),
**caractérisé en ce que**, dans l'ETFE, une transmittance de lumière est 85 % ou plus et une absorbance de lumière est 5 % ou moins dans une bande de longueurs d'ondes de 400 nm à 1 200 nm,
dans lequel le substrat (30, 40) constitué de l'ETFE a une première couche traitée en surface (41) au niveau de la surface en contact avec l'élément de scellage (50), la première couche traitée en surface (41) étant une couche d'apprêt pour renforcer une force d'adhérence avec l'élément de scellage (50),
dans lequel le substrat (30, 40) constitué de l'ETFE a une deuxième couche traitée en surface (43) au niveau de la surface opposé à la surface en contact avec l'élément de scellage (50), la deuxième couche traitée en surface (43) étant constituée d'un matériau hydrophobe pour empêcher une pénétration d'humidité.

2. Module de cellules solaires bifaces selon la revendication 1, dans lequel le substrat (30, 40) constitué d'ETFE a une transmittance de lumière de 90 % ou plus dans une bande de longueurs d'ondes de 400 nm à 1 200 nm.

3. Module de cellules solaires bifaces selon une quelconque revendication précédente, dans lequel le substrat (30, 40) constitué d'ETFE a une absorbance de lumière de 1 % ou moins dans une bande de longueurs d'ondes de 400 nm à 1 200 nm.

4. Module de cellules solaires bifaces selon une quelconque revendication précédente, dans lequel le substrat (30, 40) constitué d'ETFE est formé à une épaisseur de 30 µm à 200 µm.

5. Module de cellules solaires bifaces selon une quelconque revendication précédente, dans lequel l'élément de scellage (50) comprend une résine de silicone.

6. Module de cellules solaires bifaces selon la revendication 5, dans lequel l'élément de scellage comprend en outre un matériau fibreux (60).

7. Module de cellules solaires bifaces selon la revendication 6, dans lequel le matériau fibreux a une forme de maille et est au moins une parmi une fibre de verre, une fibre de quartz, une fibre de graphite, une fibre de nylon, une fibre de polyester, une fibre d'aramide, une fibre de polyéthylène, une fibre de polypropylène, et une fibre de carbure de silicium, et la résine de silicone est remplie dans les espaces entre des fibres individuelles du matériau fibreux.

8. Module de cellules solaires bifaces selon l'une quelconque des revendications 5 à 7, dans lequel l'élément de scellage (50) comprend une première résine de silicone (51) positionnée entre le premier substrat (30) et la cellule solaire biface (10) et une deuxième résine de silicone (53) positionnée entre la cellule solaire biface (10) et le deuxième substrat (40).

9. Module de cellules solaires bifaces selon la revendication 8, dans lequel la première résine de silicone (51) et la deuxième résine de silicone (53) ont une transmittance de lumière de 80 % ou plus dans une bande de longueurs d'ondes de 300 nm à 500 nm.
